# EUROPÄISCHE PATENTSCHRIFT

(11) **EP 3 055 098 B1**
(45) Veröffentlichungstag und Bekanntmachung des Hinweises auf die Patenterteilung: **26.09.2018**
(21) Anmeldenummer: 14781231.7
(22) Anmeldetag: 08.10.2014
(51) Int. Cl.: B23K 26/00, B28D 5/00, B23K 26/40, H01L 21/268, H01L 31/18

(54) **KOMBINIERTES WAFERHERSTELLUNGSVERFAHREN MIT LASERBEHANDLUNG UND TEMPERATURINDUZIERTEN SPANNUNGEN**
WAFER PRODUCTION METHOD
PROCÉDÉ DE FABRICATION DE TRANCHES DE SILICIUM

(30) Priorität: 08.10.2013 DE 102013016666; 03.09.2014 DE 102014013107
(43) Veröffentlichungstag der Anmeldung: 17.08.2016
(73) Patentinhaber: Siltectra GmbH, 01099 Dresden (DE)
(72) Erfinder: DRESCHER, Wolfram, 01099 Dresden (DE); RICHTER, Jan, 01277 Dresden (DE); BEYER, Christian, 09599 Freiberg (DE)
(74) Vertreter: Ascherl, Andreas
(86) Internationale Anmeldenummer: PCT/EP2014/071512
(87) Internationale Veröffentlichungsnummer: WO 2015/052220

(56) Entgegenhaltungen:
- EP-A1- 2 426 697
- WO-A2-2009/061353
- WO-A2-2013/126927
- US-A1- 2005 048 738
- US-A1- 2010 009 549
- BRUEL M ET AL: "Smart cut: a promising new SOI material technology", SOI CONFERENCE, 1995. PROCEEDINGS., 1995 IEEE INTERNATIONAL TUCSON, AZ, USA 3-5 OCT. 1995, NEW YORK, NY, USA,IEEE, US, 3. Oktober 1995 (1995-10-03), Seiten 178-179, XP010196531, DOI: 10.1109/SOI.1995.526518 ISBN: 978-0-7803-2547-0

## Beschreibung

Die vorliegende Erfindung bezieht sich auf ein Verfahren zum Herstellen von Festkörperschichten gemäß dem Gegenstand von Anspruch 1.

In vielen technischen Bereichen (z.B. Mikroelektronik- oder Photovoltaiktechnologie) werden Materialien, wie z.B. Silizium, Germanium oder Saphir, häufig in der Form dünner Scheiben und Platten (so genannte Wafer) gebraucht. Standardmäßig werden solche Wafer derzeit durch Sägen aus einem Ingot hergestellt, wobei relativ große Materialverluste ("kerf-loss") entstehen. Da das verwendete Ausgangsmaterial oft sehr teuer ist, gibt es starke Bestrebungen, solche Wafers mit weniger Materialaufwand und damit effizienter und kostengünstiger herzustellen.

Beispielsweise gehen mit den derzeit üblichen Verfahren allein bei der Herstellung von Siliziumwafern für Solarzellen fast 50% des eingesetzten Materials als "kerf-loss" verloren. Weltweit gesehen entspricht dies einem jährlichen Verlust von über 2 Milliarden Euro. Da die Kosten des Wafers den größten Anteil an den Kosten der fertigen Solarzelle ausmachen (über 40%), könnten durch entsprechende Verbesserungen der Waferherstellung die Kosten von Solarzellen signifikant reduziert werden.

Besonders attraktiv für eine solche Waferherstellung ohne kerf-loss ("kerf-free wafering") erscheinen Verfahren, die auf das herkömmliche Sägen verzichten und z.B. durch Einsatz von temperaturinduzierten Spannungen direkt dünne Wafer von einem dickeren Werkstück abspalten können. Dazu gehören insbesondere Verfahren, wie sie z.B. in PCT/US2008/012140 und PCT/EP2009/067539 beschrieben sind, wo zum Erzeugen dieser Spannungen eine auf das Werkstück aufgetragene Polymerschicht verwendet wird.

Die Polymerschicht weist bei den erwähnten Verfahren einen im Vergleich zum Werkstück um ungefähr zwei Größenordnungen höheren thermischen Ausdehnungskoeffizienten auf. Außerdem kann durch Ausnutzen eines Glasübergangs ein relativ hoher Elastizitätsmodul in der Polymerschicht erreicht werden, so dass im Schichtsystem Polymerschicht-Werkstück durch Abkühlen genügend große Spannungen induziert werden können, um die Abspaltung von Wafer vom Werkstück zu ermöglichen.

Beim Abspalten eines Wafers vom Werkstück haftet bei den erwähnten Verfahren jeweils auf einer Seite des Wafers noch Polymer an. Der Wafer krümmt sich dabei sehr stark in Richtung dieser Polymerschicht, was ein kontrolliertes Abspalten erschwert, und z.B. zu Dickenschwankungen des abgespaltenen Wafers führen kann. Außerdem erschwert die starke Krümmung die weitere Verarbeitung und kann sogar zum Zerbrechen des Wafers führen.

Bei Verwendung der Verfahren nach bisherigem Stand der Technik weisen die hergestellten Wafer üblicherweise jeweils größere Dickenschwankungen auf, wobei die räumliche Dickenverteilung häufig ein Muster mit vierzähliger Symmetrie zeigt. Die totale Dickenschwankung über den ganzen Wafer gesehen ("total thickness variation", TTV) beträgt bei Verwendung der bisherigen Verfahren häufig mehr als 100% der mittleren Waferdicke (ein Wafer von bspw. 100 Mikrometer mittlerer Dicke, der z.B. an seiner dünnsten Stelle 50 Mikrometer dick und an seiner dicksten Stelle 170 Mikrometer dick ist, hat ein TTV von 170-50=120 Mikrometer, was relativ zu seiner mittleren Dicke einer totalen Dickenschwankung von 120% entspricht). Wafer mit solch starken Dickenschwankungen sind für viele Anwendungen nicht geeignet. Außerdem liegen bei den am häufigsten auftretenden vierzähligen Dickenverteilungsmustern die Bereiche mit den größten Schwankungen unglücklicherweise in der Mitte des Wafers, wo sie am meisten stören.

Außerdem entstehen beim Verfahren nach aktuellem Stand der Technik während der Bruchpropagation beim Abspalten selbst unerwünschte Oszillationen in den beteiligten Schichtsystemen, die den Verlauf der Bruchfront ungünstig beeinflussen und insbesondere zu signifikanten Dickenschwankungen des abgespaltenen Wafers führen können.

Zudem ist es bei den bisherigen Verfahren schwierig, einen reproduzierbar guten Wärmekontakt über die ganze Fläche der Polymerschicht sicherzustellen. Lokal ungenügender Wärmekontakt kann aber aufgrund der geringen thermischen Leitfähigkeit der verwendeten Polymere zu ungewollten, signifikanten lokalen Temperaturabweichungen im Schichtsystem führen, was sich seinerseits negativ auf die Kontrollierbarkeit der erzeugten Spannungsfelder und damit die Qualität der hergestellten Wafer auswirkt.

Weiterhin ist aus der Druckschrift DE 196 40 594 A1 ein Verfahren zur Trennung von Halbleitermaterialien mittels licht-induzierter Grenzflächenzersetzung und damit hergestellter Vorrichtungen, wie strukturierte und freistehende Halbleiterschichten und Bauelemente, bekannt. Das Verfahren gemäß der DE 196 40 594 A1 beinhaltet die Beleuchtung von Grenzflächen zwischen Substrat und Halbleiterschicht oder zwischen Halbleiterschichten, wodurch die Lichtabsorption an der Grenzfläche oder in einer dafür vorgesehenen Absorptionsschicht zur Materialzersetzung führt. Die Auswahl der Grenzfläche oder Halbleiterschicht, welche zur Zersetzung gebracht wird, erfolgt durch die Wahl der Lichtwellenlänge und Lichtintensität, die Einstrahlrichtung oder den Einbau einer dünnen Opferschicht während der Materialherstellung. Dieses Verfahren hat den Nachteil, dass zur Zerstörung ganzer Schichten hohe Energiedosen verwendet werden müssen, wodurch der Energiebedarf und somit die Kosten des Verfahrens sehr hoch sind.

Weiterhin ist durch die Druckschriften EP000002390044B1, EP000001498215B1, EP000001494271B1, EP000001338371B1 ein Verfahren offenbart, bei dem der Laser zum vertikalen Trennen von Werkstücken eingesetzt wird.
Ferner sind lasergestützte Verfahren zum Erzeugen von Schadstellen innerhalb eines Wafers bekannt. Mit einem fokussierten Laser werden dabei in der Tiefe Multiphotonenanregungen erreicht, mit denen einen Schädigung in der Tiefe ohne eine Schädigung beim Materialeintritt möglich ist.
Typischerweise werden dabei Laser mit einer ns-Pulsdauer (Nanosekundenpulsdauer) eingesetzt, damit es zu einer starken Wechselwirkung von dem erwärmten Material mit dem Laser kommen kann. Typischerweise geschieht dies über ein Photon-Phonon Wechselwirkung, welche eine deutlich höhere Absorption aufweist, als die Multi-photonen Anregung.
Ein solches Verfahren ist beispielsweise durch Ohmura et. al. (Journal of Achievements in Materials and Manufacturing Engineering, 2006, vol 17, p. 381 ff) bekannt. Die von Ohmura et al. vorgeschlagene Waferbehandlung dient zur Erzeugung von Rissführungslinien durch eine Defekterzeugung innerhalb des Wafers, wie sie beim Vereinzeln von Waferelementen einer Waferplatte teilweise vorgesehen werden. Die bei diesem Verfahren erzeugten Defekte erstrecken sich dabei in vertikaler Richtung, wodurch die Verbindungsstruktur zwischen den einzelnen Waferelementen rechtwinklig zur Hauptoberfläche der Waferelemente längliche Schwächungen erfährt. Die länglichen Schwächungen weisen dabei Ausdehnungen von > 50 µm auf.
Der für das Vereinzeln von Waferelementen ausgenutzte Vorteil, nämlich die Erzeugung von Ausdehnungen mit einer vertikalen Ausdehnung von >50 µm verhindert eine Übertragung dieser Art von Defekterzeugung auf Verfahren zum Abspalten von einer oder mehreren Waferschichten von einem Festkörper. Zum einen entsteht bei einer über die Waferfläche verteilten Erzeugung dieser länglichen Defekte eine Materialschicht im Inneren des Festkörpers, die lediglich zur Rissführung genutzt werden kann, jedoch für eine spätere Verwendung ungeeignet ist und daher Ausschuss darstellt. Zum anderen muss dieser Ausschuss z.B. durch Polierverfahren entfernt werden, wodurch ein zusätzlicher Aufwand entstehen würde. Es ist somit die Aufgabe der vorliegenden Erfindung ein Verfahren zur Herstellung von Festkörperschichten oder Festkörpern bereitzustellen, das die kostengünstige Herstellung von Festkörperplatten oder unebenen Festkörpern mit einer gewünschten Dickenverteilung ermöglichen, wobei die vertikale Schädigung um die Rissebene minimiert ist.

Es ist somit die Aufgabe der vorliegenden Erfindung ein Verfahren zur Herstellung von Festkörperschichten bereitzustellen, das die kostengünstige Herstellung von Festkörperplatten bzw. Wafern mit einer gleichmäßigen Dicke ermöglicht, insbesondere mit einem TTV von weniger als 120 Mikrometer. Es besteht gemäß einem weiteren Aspekt der vorliegenden Erfindung die Aufgabe ein Verfahren zu Herstellung von einer oder mehreren Festkörperschichten bereitzustellen, bei dem eine Rissausbreitungsebene mittels einem Laser innerhalb eines Festkörpers erzeugt wird, wobei die einzelnen die Rissausbreitungsebene bildenden Defekte eine vertikale Ausdehnung von weniger als 50 µm aufweisen sollen.
Die zuvor genannte Aufgabe wird durch ein Verfahren gemäß Anspruch 1 zum Herstellen von Festkörperschichten gelöst. Das Verfahren umfasst dabei bevorzugt mindestens die Schritte, des Bereitstellens eines Werkstücks bzw. eines Festkörpers zum Abtrennen mindestens einer Festkörperschicht, des Erzeugens von Defekten mittels mindestens einer Strahlungsquelle, insbesondere einem Laser, insbesondere einem fs-Laser bzw. Femtosekundenlaser, in der inneren Struktur des Festkörpers zum Vorgeben einer Ablöseebene, entlang der die Festkörperschicht vom Festkörper abgetrennt wird, des Anordnens einer Aufnahmeschicht zum Halten der Festkörperschicht an dem Festkörper, des thermischen Beaufschlagens der Aufnahmeschicht zum, insbesondere mechanischen, Erzeugen von Spannungen in dem Festkörper, wobei sich durch die Spannungen ein Riss in dem Festkörper entlang der Ablöseebene ausbreitet, der die Festkörperschicht von dem Festkörper abtrennt.
Diese Lösung ist vorteilhaft, da aufgrund der Strahlungsquelle die Ablöseschicht bzw. Defektschicht in dem Festkörper erzeugbar ist, durch die der Riss bei der Rissausbreitung geleitet bzw. geführt wird, was die Realisierung sehr kleiner TTVs, insbesondere kleiner als 200 Mikrometer oder 100 Mikrometer oder kleiner als 80 Mikrometer oder kleiner als 60 Mikrometer oder kleiner als 40 Mikrometer oder kleiner als 20 Mikrometer oder kleiner als 10 Mikrometer oder kleiner als 5 Mikrometer, insbesondere 4, 3, 2, 1 Mikrometer, ermöglicht.

Die Strahlenbeaufschlagung des Wafers schafft somit in einem ersten Schritt eine Art Perforation im Inneren des Festkörpers, entlang der in einem zweiten Schritt die Rissausbreitung erfolgt bzw. entlang der die Festkörperschicht von dem Festkörper abgetrennt wird.

Weitere vorteilhafte Ausführungsformen sind Gegenstand der nachfolgenden Beschreibung und/oder der Unteransprüche.

Gemäß einer bevorzugten Ausführungsform der vorliegenden Erfindung hat der Laser eine Pulsdauer von unter 10ps, besonders bevorzugt unter 1 ps und am besten unter 500fs.

Die Spannungen zum Ablösen der Festkörperschicht werden gemäß einer bevorzugten Ausführungsform der vorliegenden Erfindung von dem Festkörper durch die thermische Beaufschlagung der Aufnahmeschicht, insbesondere einer Polymerschicht, erzeugt. Die thermische Beaufschlagung stellt bevorzugt ein Abkühlen der Aufnahmeschicht bzw. Polymerschicht auf oder unter die Umgebungstemperatur und bevorzugt unter 10°C und besonders bevorzugt unter 0°C und weiter bevorzugt unter -10°C dar. Die Abkühlung der Polymerschicht erfolgt höchst bevorzugt derart, dass zumindest ein Teil der Polymerschicht, die bevorzugt aus PDMS besteht, einen Glasübergang vollzieht. Die Abkühlung kann hierbei eine Abkühlung auf unter -100°C sein, die z.B. mittels flüssigen Stickstoffs bewirkbar ist. Diese Ausführungsform ist vorteilhaft, da sich die Polymerschicht in Abhängigkeit von der Temperaturveränderung zusammenzieht und/oder einen Gasübergang erfährt und die dabei entstehenden Kräfte auf den Festkörper überträgt, wodurch mechanische Spannungen in dem Festkörper erzeugbar sind, die zum Auslösen eines Risses und/oder zur Rissausbreitung führen, wobei sich der Riss zunächst entlang der ersten Ablöseebene zum Abspalten der Festkörperschicht ausbreitet.
Gemäß einer bevorzugten Ausführungsform der vorliegenden Erfindung wird der Festkörper an einer Halteschicht zum Halten des Festkörpers angeordnet, wobei die Halteschicht an einem ersten ebenen Flächenanteil des Festkörpers angeordnet wird, wobei der erste ebene Flächenanteil des Festkörpers von einem zweiten ebenen Flächenanteil des Festkörpers beabstandet ist, wobei am zweiten ebenen Flächenanteil die Polymerschicht angeordnet ist und wobei die Ablöseebene gegenüber dem ersten ebenen Flächenanteil und/oder dem zweiten ebenen Flächenanteil parallel ausgerichtet wird bzw. parallel erzeugt wird.

Diese Ausführungsform ist vorteilhaft, da der Festkörper zumindest abschnittweise und bevorzugt vollständig zwischen der Halteschicht und der Polymerschicht angeordnet ist, wodurch mittels einer dieser Schichten oder mittels beider Schichten die Spannungen zur Risserzeugung bzw. Rissausbreitung in den Festkörper einleitbar sind.

Mindestens oder genau ein Laser ist gemäß einer weiteren bevorzugten Ausführungsform der vorliegenden Erfindung zum Bereitstellen der in den Festkörper einzubringenden Strahlung derart konfiguriert, dass die von ihr ausgestrahlten Strahlen die Defekte an vorbestimmten Orten innerhalb des Festkörpers erzeugen. Diese Ausführungsform ist vorteilhaft, da mittels einer Strahlungsquelle, insbesondere mittels eines Lasers, äußerst genau Defekte in dem Festkörper erzeugbar sind.

Für das Verfahren ergeben sich insbesondere zwei Anwendungsfälle, im Folgenden "Wafering" und "thinning" genannt. Beim "Wafering" wird das Verfahren üblicherweise dafür genutzt eine dicke Schicht von einem noch dickeren Halbleiterblock abzulösen, typischerweise einen Wafer (mit den industriespezifischen Dicken) von einem Ingot. Beim "Thinning" wird das Verfahren dafür eingesetzt, von einem Wafer eine sehr dünne Schicht abzuspalten, was dem heutigen Prozess des grindings entspricht, allerdings mit dem Vorteil, dass das nicht benötigte Material unversehrt bleibt und wiederverwendet werden kann. Eine klare Trennung von "thinning" und "Wafering" ist kompliziert, weil z.B. das "thinning" auch durch Beaufschlagung von der Rückseite eines Wafers geschehen kann, so dass zwar eine dünne Schicht entsteht, der Laser aber tief in das Material eindringt.

### Für den "thinning" Fall :

Der Laser wird gemäß einer weiteren bevorzugten Ausführungsform der vorliegenden Erfindung derart eingestellt, dass die von ihr ausgestrahlten Strahlen zum Erzeugen der Ablöseebene auf eine definierte Tiefe, insbesondere <100µm, in den Festkörper eindringen. Bevorzugt wird die Ablöseebene parallel beabstandet zu einer äußeren und bevorzugt ebenen Oberfläche des Festkörpers ausgebildet. Bevorzugt ist die Ablöseebene weniger als 100 Mikrometer und bevorzugt weniger als 50 Mikrometer und besonders bevorzugt weniger als oder gleich 20, 10, 5 oder 2 Mikrometer von der ebenen Oberfläche des Festkörpers beabstandet innerhalb des Festkörpers ausgebildet. Somit wird die Ablöseebene bevorzugt in Form einer aus Defekten erzeugten Ebene ausgebildet, wobei die Defekte weniger als 100 Mikrometer und bevorzugt weniger als 50 Mikrometer und besonders bevorzugt weniger als 20, 10 oder 2 Mikrometer von der ebenen Oberfläche des Festkörpers beabstandet innerhalb des Festkörpers ausgebildet werden.

### Für den "wafering" Fall :

Der Laser wird gemäß einer weiteren bevorzugten Ausführungsform der vorliegenden Erfindung derart eingestellt, dass die von ihr ausgestrahlten Strahlen zum Erzeugen der Ablöseebene auf eine definierte Tiefe, insbesondere >100µm, in den Festkörper eindringen. Bevorzugt wird die Ablöseebene parallel beabstandet zu einer äußeren und bevorzugt ebenen Oberfläche des Festkörpers ausgebildet. Bevorzugt ist die Ablöseebene mehr als 100 Mikrometer und bevorzugt mehr als 200 Mikrometer und besonders bevorzugt mehr als 400 oder 700 Mikrometer von der ebenen Oberfläche des Festkörpers beabstandet innerhalb des Festkörpers ausgebildet. Somit wird die Ablöseebene bevorzugt in Form einer aus Defekten erzeugten Ebene ausgebildet, wobei die Defekte mehr als 100 Mikrometer und bevorzugt mehr als 200 Mikrometer und besonders bevorzugt mehr als 400 oder 700 Mikrometer von der ebenen Oberfläche des Festkörpers beabstandet innerhalb des Festkörpers ausgebildet werden.
Der Festkörper wird gemäß einer weiteren bevorzugten Ausführungsform der vorliegenden Erfindung mit einer vorgegebenen Wellenlänge und/oder Leistung beaufschlagt, wobei die vorgegebene Wellenlänge bevorzugtan das jeweilige Material bzw. Substrat angepasst ist. Diese Ausführungsform ist vorteilhaft, da die Defektgröße durch die Wellenlänge und/oder die Leistung beeinflussbar ist.

Der Festkörper weist gemäß einer weiteren bevorzugten Ausführungsform der vorliegenden Erfindung Silizium und/oder Gallium oder Perowskit auf und die Polymerschicht und/oder die Halteschicht bestehen zumindest teilweise und bevorzugt vollständig oder zu mehr als 75% aus Polydimethylsiloxane (PDMS), wobei die Halteschicht an einer zumindest abschnittsweise ebenen Fläche einer Stabilisierungseinrichtung angeordnet ist, die zumindest teilweise aus mindestens einem Metall besteht. Die Stabilisierungseinrichtung ist bevorzugt eine Platte, insbesondere eine Platte die Aluminium aufweist oder daraus besteht. Diese Ausführungsform ist vorteilhaft, da durch die Stabilisierungseinrichtung und die Halteschicht der Festkörper definiert bzw. fest gehalten wird, wodurch die Spannungen sehr genau in dem Festkörper erzeugt werden können.

Gemäß einer weiteren bevorzugten Ausführungsform der vorliegenden Erfindung sind die Spannungen in dem Festkörper derart einstellbar bzw. erzeugbar, dass die Rissauslösung und/oder die Rissausbreitung zum Erzeugen einer Topografie der sich in der Rissebene ergebenden Oberfläche steuerbar ist. Die Spannungen sind somit bevorzugt in unterschiedlichen Bereichen des Festkörpers bevorzugt zumindest zeitweise unterschiedlich stark erzeugbar. Diese Ausführungsform ist vorteilhaft, da durch Steuerung der Rissauslösung und/oder des Rissverlaufs die Topographie der erzeugten bzw. abgetrennten Festkörperschicht vorteilhaft beeinflussbar ist.

Gemäß einer weiteren bevorzugten Ausführungsform der vorliegenden Erfindung geben die Defekte mindestens eine Rissführungsschicht vor, wobei die mindestens eine Rissführungsschicht eine von einer ebenen Gestalt abweichende Gestalt aufweist. Diese Lösung ist vorteilhaft, da die erzeugten Festkörperschichten oder die erzeugten Festkörper eine von einer ebenen Schicht abweichende Gestalt aufweisen können. Es können somit nicht mehr nur ebene Schichten, sondern ebenfalls dreidimensionale Körper aus einem Werkstück mittels einer Rissausbreitung herausgebildet bzw. erzeugt werden. Derart hergestellte Festkörper weisen aufgrund des Herstellungsverfahrens eine sehr vorteilhafte und nur wenig bis nicht nachzubearbeitende Oberfläche auf. So sind z.B. optische Elemente, wie z.B. ein Spat oder eine Linse in einem einstufigen oder mehrstufigen, insbesondere zwei oder dreistufigen, Splitprozess herstellbar.
Die Gestalt der Rissführungsschicht weist somit gemäß einer bevorzugten Ausführungsform der vorliegenden Erfindung zumindest abschnittsweise die Kontur eines dreidimensionalen Objektes, insbesondere einer Linse oder eines Spaten, auf.
Gemäß einer bevorzugten Ausführungsform der vorliegenden Erfindung werden die Defekte mittels einer Defekterzeugungsvorrichtung bzw. der Strahlungsquelle erzeugt, wobei die Defekterzeugungsvorrichtung derart konfiguriert ist, dass die Defekte mit einem konstanten Abstand zur Defekterzeugungsvorrichtung in dem Werkstück erzeugt werden, wobei das Werkstück und die Defekterzeugungsvorrichtung derart relativ zueinander geneigt werden, dass die von der Defekterzeugungsvorrichtung erzeugten Defekte in der Rissführungsschicht erzeugt werden, wobei die Defekterzeugungsvorrichtung und das Werkstück während der Defekterzeugung lediglich zweidimensional zueinander umpositioniert werden. Die Defekterzeugungsvorrichtung wird somit bevorzugt gegenüber dem Werkstück umpositioniert oder das Werkstück wird gegenüber der Defekterzeugungsvorrichtung umpositioniert oder die Defekterzeugungsvorrichtung und das Werkstück werden beide zueinander umpositioniert.
Diese Ausführungsform ist vorteilhaft, da die Strahlungsquelle bzw. die Defekterzeugungseinrichtung zur Defekterzeugung lediglich umpositioniert werden muss und keine Modifikation der Defekterzeugungsvorrichtung bewirkt werden muss, insbesondere keine veränderte Defekteinbringtiefe bestimmt und eingestellt werden muss.

Die Defekte werden gemäß einer weiteren bevorzugten Ausführungsform mittels einer Defekterzeugungsvorrichtung bzw. der Strahlungsquelle erzeugt, wobei die Defekterzeugungsvorrichtung derart konfiguriert ist, dass die Defekte mit einem sich zeitweise veränderndem Abstand zur Defekterzeugungsvorrichtung in dem Werkstück erzeugt werden, wobei in Abhängigkeit von dem Abstand der Defekterzeugungsvorrichtung zu dem zu erzeugenden Defekts zumindest zeitweise eine Modifikation der Defekterzeugungsvorrichtung bewirkt wird, insbesondere eine veränderte Defekteinbringtiefe bestimmt und eingestellt wird. Diese Ausführungsform ist vorteilhaft, da bevorzugt keine Neigungsvorrichtung zum Neigen des Werkstücks vorgesehen werden muss.

Der Festkörper weist bevorzugt ein Material oder eine Materialkombination aus einer der Hauptgruppen 3, 4 und 5 des Periodensystems der Elemente auf, wie z.B. Si, SiC, SiGe, Ge, GaAs, InP, GaN, Al2O3 (Saphir), AIN. Besonders bevorzugt weist der Festkörper eine Kombination aus in der dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann der Festkörper eine Keramik (z.B. Al2O3 - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Der Festkörper weist somit bevorzugt ein Halbleitermaterial oder ein Keramikmaterial auf bzw. besonders bevorzugt besteht der Festkörper aus mindestens einem Halbleitermaterial oder einem Keramikmaterial. Es ist weiterhin denkbar, dass der Festkörper ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAlSb, Hochtemperatursupraleiter, insbesondere seltene Erden Cuprate (z.B. YBa2Cu3O7).
Gemäß einer weiteren bevorzugten Ausführungsform der vorliegenden Erfindung ist der Laser als Femtosekundenlaser (fs-Laser) ausgebildet. Diese Lösung ist vorteilhaft, da durch die Verwendung eines fs-Laser, die vertikale Ausbreitung des gestörten Materials minimiert wird. Es ist durch die Verwendung eines fs-Lasers möglich Defekte in dem Werkstück sehr genau einzubringen bzw. darin zu erzeugen. Die Wellenlänge und/oder die Energie des fs-Laser sind bevorzugt materialabhängig zu wählen.

Gemäß einer weiteren bevorzugten Ausführungsform der vorliegenden Erfindung wird die Energie der Strahlungsquelle, insbesondere des Laserstrahls, insbesondere des fs-Lasers, derart gewählt, dass die Schädigungsausbreitung im Festkörper bzw. im Kristall kleiner als dreimal die Reyleighlänge, bevorzugt kleiner als die Reyleighlänge und besonders bevorzugt kleiner als ein Drittel der Reyleighlänge ist.
Die Wellenlänge des Laserstrahls, insbesondere des fs-Lasers, wird gemäß einer weiteren bevorzugten Ausführungsform der vorliegenden Erfindung derart gewählt, dass die Absorption des Festkörpers bzw. des Materials kleiner als 10cm⁻¹ und bevorzugt kleiner als 1cm⁻¹ und besonders bevorzugt kleiner als 0,1cm⁻¹ ist.
Die einzelnen Defekte resultieren gemäß einer weiteren bevorzugten Ausführungsform der vorliegenden Erfindung jeweils aus einer von der Strahlungsquelle, insbesondere dem Laser, insbesondere einem fs-Laser, bewirkten multi-photonen Anregung.

Weitere Vorteile, Ziele und Eigenschaften der vorliegenden Erfindung werden anhand nachfolgender Beschreibung anliegender Zeichnungen erläutert, in welchen beispielhaft die erfindungsgemäße Waferherstellung dargestellt ist. Bauteile oder Elemente der erfindungsgemäßen Waferherstellung, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.
Einzelne oder alle Darstellungen der im Nachfolgenden beschriebenen Figuren sind bevorzugt als Konstruktionszeichnungen anzusehen, d.h. die sich aus der bzw. den Figuren ergebenden Abmessungen, Proportionen, Funktionszusammenhänge und/oder ergebenden Abmessungen, Proportionen, Funktionszusammenhänge und/oder Anordnungen entsprechen bevorzugt genau oder bevorzugt im Wesentlichen denen der erfindungsgemäßen Vorrichtung bzw. des erfindungsgemäßen Produkts.

Darin zeigen:
- Fig. 1a: einen schematischen Aufbau zum Erzeugen von Defekten in einem Festkörper;
- Fig. 1b: eine schematische Darstellung einer Schichtanordnung vor dem Abtrennen einer Festkörperschicht von einem Festkörper;
- Fig. 1c: eine schematische Darstellung einer Schichtanordnung nach dem Abtrennen einer Festkörperschicht von einem Festkörper;
- Fig. 2a: eine erste schematisch dargestellte Variante zur Defekterzeugung mittels Lichtwellen;
- Fig. 2b: eine zweite schematisch dargestellte Variante zur Defekterzeugung mittels Lichtwellen; und
- Fig. 3: eine schematische Darstellung der Ablöseebene.

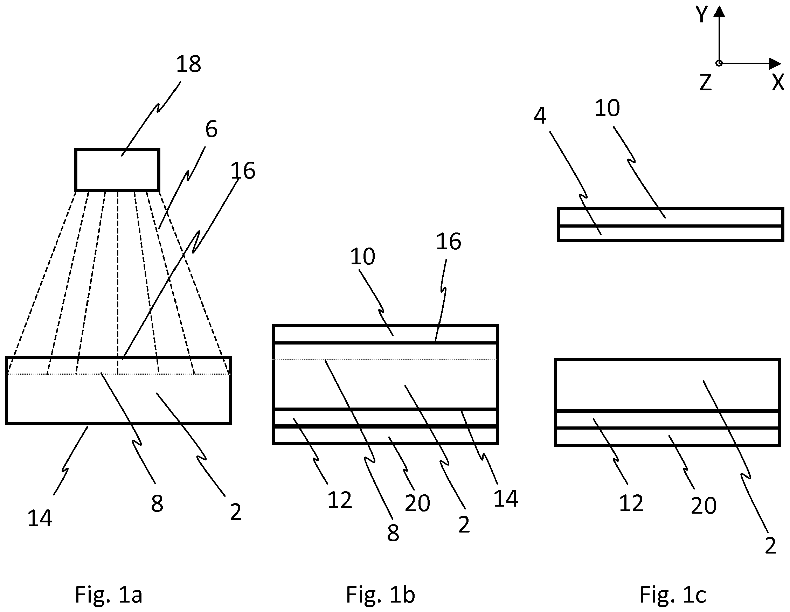

In Fig. 1a ist ein Festkörper 2 bzw. ein Substrat gezeigt, das im Bereich einer Strahlungsquelle 18, insbesondere einem Laser, angeordnet ist. Der Festkörper 2 weist bevorzugt einen ersten ebenen Flächenanteil 14 und einen zweiten ebenen Flächenanteil 16 auf, wobei der erste ebene Flächenanteil 14 bevorzugt im Wesentlichen oder genau parallel zu dem zweiten ebenen Flächenanteil 16 ausgerichtet ist. Der erste ebene Flächenanteil 14 und der zweite ebene Flächenanteil 16 begrenzen bevorzugt den Festkörper 2 in einer Y-Richtung, die bevorzugt vertikal bzw. lotrecht ausgerichtet ist. Die ebenen Flächenanteile 14 und 16 erstrecken sich bevorzugt jeweils in einer X-Z-Ebene, wobei die X-Z-Ebene bevorzugt horizontal ausgerichtet ist. Weiterhin lässt sich dieser Darstellung entnehmen, dass die Strahlungsquelle 18 Stahlen 6 auf den Festkörper 2 ausstrahlt. Die Strahlen 6 dringen je nach Konfiguration definiert tief in den Festkörper 2 ein und erzeugen an der jeweiligen Position bzw. an einer vorbestimmten Position einen Defekt.

In Fig. 1b ist eine mehrschichtige Anordnung gezeigt, wobei der Festkörper 2 die Ablöseebene 8 beinhaltet und im Bereich des ersten ebenen Flächenanteils 14 mit einer Halteschicht 12 versehen ist, die wiederum bevorzugt von einer weiteren Schicht 20 überlagert wird, wobei die weitere Schicht 20 bevorzugt eine Stabilisierungseinrichtung, insbesondere eine Metallplatte, ist. An dem zweiten ebenen Flächenanteil 16 des Festkörpers 2 ist bevorzugt eine Polymerschicht 10 angeordnet. Die Polymerschicht 10 und/oder die Halteschicht 12 bestehen bevorzugt zumindest teilweise und besonders bevorzugt vollständig aus PDMS.

In Fig. 1c ist ein Zustand nach einer Rissauslösung und anschließender Rissführung gezeigt. Die Festkörperschicht 4 haftet an der Polymerschicht 10 und ist von dem verbleibenden Rest des Festkörpers 2 beabstandet bzw. beabstandbar.

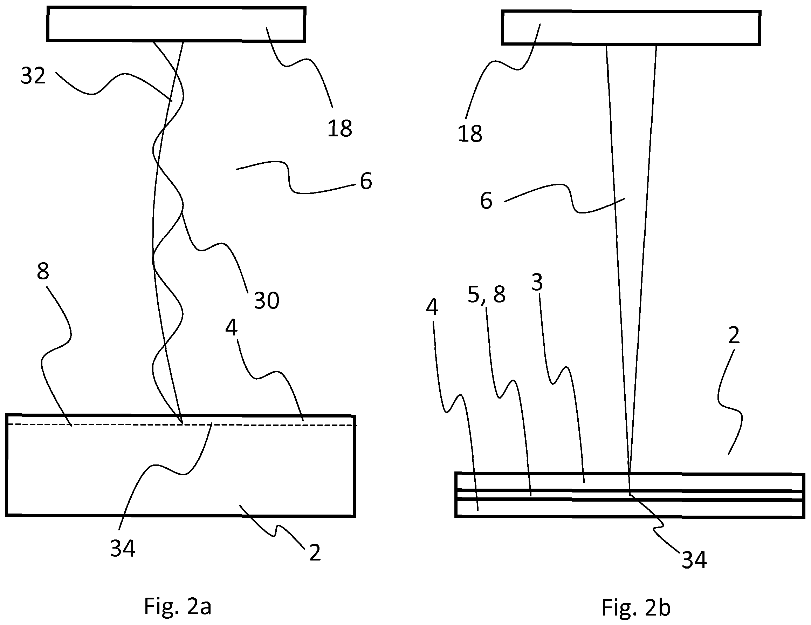

In den Figuren 2a und 2b sind Beispiele für die in Fig. 1a gezeigte Erzeugung einer Ablöseebene 8 durch die Einbringung von Defekten in einen Festkörper 2 mittels Lichtstrahlen gezeigt.

Die vorliegende Erfindung bezieht sich somit auf ein Verfahren zum Herstellen von Festkörperschichten. Das erfindungsgemäße Verfahren umfasst dabei mindestens die Schritte des Bereitstellens eines Festkörpers 2 zum Abtrennen mindestens einer Festkörperschicht 4, des Erzeugens von Defekten mittels mindestens einer Strahlungsquelle, insbesondere mindestens einem Laser, insbesondere mindestens einem fs-Laser, in der inneren Struktur des Festkörpers zum Vorgeben einer Ablöseebene, entlang der die Festkörperschicht vom Festkörper abgetrennt wird, und des thermischen Beaufschlagens einer an dem Festkörper 2 angeordneten Polymerschicht 10 zum, insbesondere mechanischen, Erzeugen von Spannungen in dem Festkörper 2, wobei sich durch die Spannungen ein Riss in dem Festkörper 2 entlang der Ablöseebene 8 ausbreitet, der die Festkörperschicht 4 von dem Festkörper 2 abtrennt.

In Fig. 2a ist somit schematisch gezeigt, wie Defekte 34 in einem Festkörper 2, insbesondere zur Erzeugung einer Ablöseebene 8 mittels einer Strahlungsquelle 18, insbesondere einem oder mehrerer Laser, insbesondere einem oder mehrerer fs-Laser, erzeugbar ist. Die Strahlungsquelle 18 emittiert dabei Strahlung 6 mit einer ersten Wellenlänge 30 und einer zweiten Wellenlänge 32. Die Wellenlängen 30, 32 sind dabei derart aufeinander abgestimmt bzw. die Distanz zwischen der Strahlungsquelle 18 und der zu erzeugenden Ablöseebene 8 ist derart abgestimmt, dass die Wellen 30, 32 im Wesentlichen oder genau auf der Ablöseebene 8 in dem Festkörper 2 zusammentreffen, wodurch am Ort des Zusammentreffens 34 infolge der Energien beider Wellen 30, 32 ein Defekt erzeugt wird. Die Defekterzeugung kann dabei durch unterschiedliche oder kombinierte Zersetzungsmechanismen wie z.B. Sublimation oder chemische Reaktion erfolgen, wobei die Zersetzung dabei z.B. thermisch und/oder photochemisch initiiert werden kann.

In Fig. 2b ist ein fokussierter Lichtstrahl 6 gezeigt, dessen Brennpunkt bevorzugt in der Ablöseebene 8 liegt. Es ist hierbei denkbar, dass der Lichtstrahl 6 durch eine oder mehrere fokussierende Körper, insbesondere Linse/n (nichtgezeigt), fokussiert wird. Der Festkörper 2 ist in dieser Ausführungsform mehrschichtig ausgebildet und weist bevorzugt eine teiltransparente oder transparente Substratschicht 3 bzw. Materialschicht auf, die bevorzugt aus Saphir besteht oder Saphir aufweist. Die Lichtstrahlen 6 gelangen durch die Substratschicht 3 auf die Ablöseebene 8, die bevorzugt durch eine Opferschicht 5 gebildet wird, wobei die Opferschicht 5 durch die Strahlung derart beaufschlagt wird, dass thermisch und/oder photochemisch eine teilweise oder vollständige Zerstörung der Opferschicht 5 in dem Brennpunkt bzw. im Bereich des Brennpunkts bewirkt wird. Es ist ebenfalls denkbar, dass die Defekte zur Erzeugung der Ablöseschicht 8 im Bereich oder genau auf einer Grenzfläche zwischen zwei Schichten 3, 4 erzeugt werden. Somit ist ebenfalls denkbar, dass die Festkörperschicht 4 auf einer Trägerschicht, insbesondere einer Substratschicht 3, erzeugt wird und mittels einer oder mehrerer Opferschichten 5 und/oder mittels der Erzeugung von Defekten in einer Grenzfläche, insbesondere zwischen der Festkörperschicht 4 und der Trägerschicht, eine Ablöseebene 8 zum Ablösen bzw. Abtrennen der Festkörperschicht 4 erzeugbar ist.

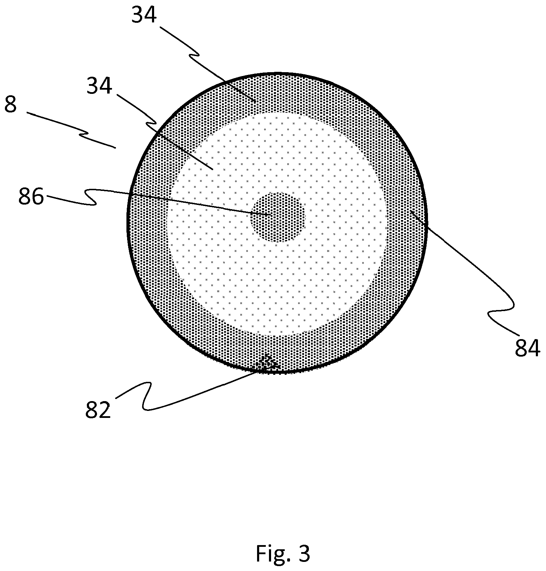

In Fig. 3 ist eine Ablöseebene 8 gezeigt, die Bereiche mit unterschiedlichen Defektkonzentrationen 82, 84, 86 aufweist. Es ist hierbei denkbar, dass eine Vielzahl an Bereichen mit unterschiedlichen Defektkonzentrationen eine Ablöseebene 8 bilden, wobei ebenfalls vorstellbar ist, dass die Defekte 34 in der Ablöseebene 8 im Wesentlichen oder genau gleichmäßig über die Fläche verteilt sind. Die unterschiedlichen Defektkonzentrationen können flächenmäßig gleich groß oder verschieden groß ausgebildet sein. Bevorzugt stellt eine erste erhöhte Defektkonzentration eine Rissauslösekonzentration 82 dar, die bevorzugt im Bereich des Randes oder sich zum Rand hin erstreckend bzw. den Rand benachbarend erzeugt wird. Zusätzlich oder alternativ kann eine Rissführungskonzentration 84 derart ausgebildet werden, dass der die Festkörperschicht 4 von dem Festkörper 2 abtrennende Riss kontrollierbar bzw. steuerbar ist. Weiterhin kann zusätzlich oder alternativ eine Zentrumskonzentration 86 erzeugt werden, die bevorzugt eine sehr ebene Oberfläche im Bereich des Zentrums des Festkörpers 2 ermöglicht. Bevorzugt ist die Rissführungskonzentration 84 teilweise oder vollständig ringförmig bzw. umschließend ausgebildet und umschließt somit bevorzugt abschnittsweise und besonders bevorzugt vollständig das Zentrum des Festkörpers 2 bzw. der Festkörperschicht 4. Es ist ferner denkbar, dass die Rissführungskonzentration 84 in einem ausgehend vom Rand des Festkörpers 2 und in Richtung Zentrum des Festkörpers 2 stufenweise oder stetig bzw. fließend abnimmt. Weiterhin ist denkbar, dass die Rissführungskonzentration 84 bandartig und homogen bzw. im Wesentlichen oder genau homogen ausgebildet ist.

### Bezugszeichenliste

- 2: Festkörper
- 3: Substrat
- 4: Festkörperschicht
- 5: Opferschicht
- 6: Strahlung
- 8: Ablöseebene
- 10: Polymerschicht
- 12: Halteschicht
- 14: erster ebener Flächenanteil
- 16: zweiter ebener Flächenanteil
- 18: Strahlungsquelle
- 20: Stabilisierungseinrichtung
- 30: erster Strahlungsanteil
- 32: zweiter Strahlungsanteil
- 34: Ort der Defekterzeugung
- 82: Rissauslösekonzentration
- 84: Rissführungskonzentration
- 86: Zentrumskonzentration
- X: erste Richtung
- Y: zweite Richtung
- Z: dritte Richtung

## Patentansprüche

1. Verfahren zum Herstellen von Festkörperschichten,
mindestens umfassend die Schritte:
Bereitstellen eines Festkörpers (2) zum Abtrennen mindestens einer Festkörperschicht (4), wobei der Festkörper (2) einen ersten ebenen Flächenanteil (14) und einen zweiten ebenen Flächenanteil (16) aufweist, wobei der erste ebene Flächenanteil (14) bevorzugt im Wesentlichen oder genau parallel zu dem zweiten ebenen Flächenanteil (16) ausgerichtet ist.
Erzeugen von Defekten mittels Laserstrahlen mindestens eines Lasers, in der inneren Struktur des Festkörpers zum Vorgeben einer Ablöseebene, entlang der die Festkörperschicht vom Festkörper abgetrennt wird, wobei die Laserstrahlen über den zweiten ebenen Flächenanteil (16) in den Festkörper (2) eindringen.
Anordnen einer Aufnahmesohicht (10) zum Halten der Festkörperschicht (4) an dem Festkörper (2), wobei die Aufnahmeschicht (10) am zweiten ebenen Flächenanteil (16) angeordnet ist und wobei die Aufnahmeschicht (10) als Polymerschicht ausgebildet ist,
thermisches Beaufschlagen der Aufnahmeschicht (10) zum, insbesondere mechanischen, Erzeugen von Spannungen in dem Festkörper (2), wobei die thermische Beaufschlagung ein Abkühlen der Aufnahmeschicht auf eine Temperatur unterhalb der Umgebungstemperatur darstellt, wobei die Abkühlung derart erfolgt, dass zumindest ein Teil der Polymerschicht einen Glasübergang vollzieht und wobei sich durch die Spannungen ein Riss in dem Festkörper (2) entlang der Ablöseebene (8) ausbreitet, der die Festkörperschicht (4) von dem Festkörper (2) abtrennt.

2. Verfahren nach Anspruch 1,
**dadurch gekennzeichnet, dass**
der mindestens eine Laser (18) zum Bereitstellen der In den Festkörper (2) einzubringenden Strahlung (6) derart konfiguriert ist, dass die von ihr ausgestrahlten Strahlen (6) die Defekte an vorbestimmten Orten innerhalb des Festkörpers (2) erzeugen.

3. Verfahren nach Anspruch 2,
**dadurch gekennzeichnet, dass**
der Laser (18) derart eingestellt wird, dass die von Ihr ausgestrahlten Strahlen (6) zum Erzeugen der Ablöseebene (8) auf eine definierte Tiefe von weniger als 200 µm, bevorzugt von weniger als 100µm und weiter bevorzugt von weniger als 50µm und besonders bevorzugt von weniger als 20µm in den Festkörper (2) eindringen.

4. Verfahren nach Anspruch 2,
**dadurch gekennzeichnet, dass**
der Laser (18) derart eingestellt wird, dass die von ihm ausgestrahlten Strahlen (6) zum Erzeugen der Ablöseebene (8) auf eine definierte Tiefe von mehr als 100 µm, bevorzugt von mehr als 200 µm und weiter bevorzugt von mehr als 400 µm und besonders bevorzugt von mehr als 700 µm in den Festkörper (2) eindringen,

5. Verfahren nach einem der vorangegangenen Ansprüche,
**dadurch gekennzeichnet, dass**
der Festkörper (2) an einer Halteschicht (12) zum Halten des Festkörpers (2) angeordnet wird, wobei die Halteschlcht (12) an einem ersten ebenen Flächenanteil (14) des Festkörpers (2) angeordnet wird, wobei der erste ebene Flächenanteil (14) des Festkörpers (2) von einem zweiten ebenen Flächenanteil (16) des Festkörpers (2) beabstandet ist und wobei die Ablöseebene (6) gegenüber dem ersten ebenen Flächenanteil (14) und/oder dem zweiten ebenen Flächenanteil (16) parallel ausgerichtet wird.

6. Verfahren nach einem der vorangegangenen Ansprüche,
**dadurch gekennzeichnet, dass**
der Festkörper (2) Siliziumcarbid und/oder Galliumarsenit und/oder ein keramisches Material aufweist und die Aufnahmeschicht aus einer Polymerschicht (10) besteht, wobei die Polymerschicht und/oder die Halteschicht (12) zumindest teilweise aus PDMS bestehen, wobei die Halteschicht (12) an einer zumindest abschnittsweise ebenen Fläche einer Stabilisierungseinrichtung (20) angeordnet Ist, die zumindest teilweise aus mindestens einem Metall besteht.

7. Verfahren nach einem der vorangegangenen Ansprüche,
**dadurch gekennzeichnet, dass**
der Laser ein Femtosekunden-Laser ist.

8. Verfahren nach einem der vorangegangenen Ansprüche,
**dadurch gekennzeichnet, dass**
der Laser eine Pulsdauer von unter 10 ps bevorzugt von unter 1 ps und besonders bevorzugt von unter 500 fs erzeugt.

9. Verfahren nach einem der vorangegangenen Ansprüche,
**dadurch gekennzeichnet, dass**
die Energie des Laserstrahls, insbesondere des Femtosekunden-Lasers, derart gewählt wird, dass die Schädigungsausbreitung im Festkörper kleiner als 3 mal die Rayleighlänge, bevorzugt kleiner als die Rayleighlänge und besonders bevorzugt kleiner als ein Drittel der Rayleighlänge ist.

10. Verfahren nach einem der vorangegangenen Ansprüche,
**dadurch gekennzeichnet, dass**
die Wellenlänge des Laserstrahls, insbesondere des Femtosekunden-Lasers, derart gewählt wird, dass die Absorption des Festkörpers kleiner als 10cm⁻¹ und bevorzugt kleiner als 1cm⁻¹ und besonders bevorzugt kleiner als 0,1cm⁻¹ ist.

11. Verfahren nach einem der vorangegangenen Ansprüche,
**dadurch gekennzeichnet, dass**
sich die einzelnen Defekte Jeweils In Folge einer von dem Femtosekunden-Laser bewirkten multi-photonen Anregung ergeben.

## Claims

1. A method for the manufacture of solid body layers,
at least comprising the steps:
providing a solid body (2) for the separation of at least one solid body layer (4), the solid body (2) comprising a first planar surface portion (14) and a second planar surface portion (16), wherein the first planar surface portion (14) is preferably orientated substantially or precisely parallel to the second planar surface portion (16),
producing defects by means of laser beams of at least one laser, in the interior structure of the solid body to define a separation plane, along which the solid body layer is detached from the solid body, the laser beams penetrating into the solid body (2) via the second planar surface portion (16),
arranging a receiving layer (10) for retaining the solid body layer (4) on the solid body (2), wherein the receiving layer (10) is arranged on the second planar surface portion (16) and wherein the receiving layer (10) is formed as a polymer layer,
thermally treating the receiving layer (10) for, in particular mechanically, producing stresses in the solid body (2), wherein the thermal treatment represents a cooling of the receiving layer to a temperature below the ambient temperature, wherein the cooling is effected such that at least a part of the polymer layer performs a glass transition and wherein, due to the stresses, a break spreads in the solid body (2) along the separation plane (8), which separates the solid body layer (4) from the solid body (2).

2. A method according to claim 1,
**characterised in that**
the at least one laser (18) for supplying the radiation (6) to be introduced into the solid body (2) is configured such that the beams (6) radiated thereby produce the defects at predetermined locations within the solid body (2).

3. A method according to claim 2,
**characterised in that**
the laser (18) is set such that the beams (6) radiated thereby to produce the separation plane (8) penetrate to a defined depth of less than 200µ, preferably less than 100µ and further preferably less than 50µ and especially preferably less than 20µ into the solid body (2).

4. A method according to claim 2,
**characterised in that**
the laser (18) is set such that the beams (6) radiated thereby to produce the separation plane (8) penetrate to a defined depth of more than 100µ, preferably more than 200µ and preferably more than 400µ and especially preferably more than 700µ into the solid body (2).

5. A method according to one of the preceding claims,
**characterised in that**
the solid body (2) is arranged on a retaining layer (12) for holding the solid body (2), the retaining layer (12) being arranged on a first planar surface portion (14) of the solid body (2), wherein the first planar surface portion (14) of the solid body (2) is spaced from a second planar surface portion (16) of the solid body (2) and wherein the separation plane (8) is orientated parallel relative to the first planar surface portion (14) and/or the second planar surface portion (16).

6. A method according to one of the preceding claims,
**characterised in that**
the solid body (2) comprises silicon carbide and/or gallium arsenite and/or a ceramic material and the receiver layer consists of a polymer layer (10), wherein the polymer layer and/or the retaining layer (12) consist at least partly of PDMS, the retaining layer (12) being arranged on a surface, which is planar at least in parts, of a stabilisation arrangement (20), which consists at least partly of at least one metal.

7. A method according to one of the preceding claims,
**characterised in that**
the laser is a femtosecond laser.

8. A method according to one of the preceding claims,
**characterised in that**
the laser produces a pulse duration of below lOps preferably of below 1ps and especially preferably of below 500fs.

9. A method according to one of the preceding claims,
**characterised in that**
the energy of the laser beam, especially the femtosecond laser, is selected such that the damage propagation in the solid body is smaller than 3 times the Rayleigh length, preferably smaller than the Rayleigh length and especially preferably smaller than one third of the Rayleigh length.

10. A method according to one of the preceding claims,
**characterised in that**
the wavelength of the laser beam, especially the femtosecond laser, is selected such that the absorption of the solid body is smaller than 10cm⁻¹ and preferably smaller than 1cm⁻¹ and especially preferably smaller than 0.1cm⁻¹.

11. A method according to one of the preceding claims,
**characterised in that**
the individual defects each arise as the result of a multi-photo excitation effected by the femtosecond laser.

## Revendications

1. Procédé servant à fabriquer des couches de corps solides,
comprenant au moins les étapes :
de fourniture d'un corps solide (2) servant à séparer au moins une couche de corps solide (4), dans lequel le corps solide (2) présente une première partie de surface plane (14) et une deuxième partie de surface plane (16), dans lequel la première partie de surface plane (14) est orientée de manière préférée sensiblement ou précisément de manière parallèle par rapport à la deuxième partie de surface plane (16),
de production de défauts au moyen de rayons laser d'au moins un laser, dans la structure intérieure du corps solide servant à prédéfinir un plan de décollement, le long duquel la couche de corps solide est séparée du corps solide, dans lequel les rayons laser pénètrent dans le corps solide (2) par l'intermédiaire de la deuxième partie de surface plane (16),
de disposition d'une couche de réception (10) servant à maintenir la couche de corps solide (4) au niveau du corps solide (2), dans lequel la couche de réception (10) est disposée au niveau de la deuxième partie de surface plane (16) et dans lequel la couche de réception (10) est réalisée sous la forme d'une couche polymère ;
de sollicitation thermique de la couche de réception (10) pour produire, en particulier de manière mécanique, des tensions dans le corps solide (2), dans lequel la sollicitation thermique constitue un refroidissement de la couche de réception à une température inférieure à la température ambiante, dans lequel le refroidissement est effectué de telle manière qu'au moins une partie de la couche polymère accomplit une transition vitreuse et dans lequel une fissure se propage du fait des tensions dans le corps solide (2) le long du plan de décollement (8), qui sépare la couche de corps solide (4) du corps solide (2).

2. Procédé selon la revendication 1,
**caractérisé en ce que**
l'au moins un laser (18) servant à fournir le rayonnement (6) à introduire dans le corps solide (2) est configuré de telle manière que les rayons (6) émis par le laser produisent les défauts au niveau d'emplacements prédéfinis à l'intérieur du corps solide (2) .

3. Procédé selon la revendication 2,
**caractérisé en ce que**
le laser (18) est réglé de telle manière que les rayons (6) émis par le laser pénètrent pour produire le plan de décollement (8) sur une profondeur définie inférieure à 200 µm, de manière préférée inférieure à 100 µm et de manière davantage préférée inférieure à 50 µm et de manière particulièrement préférée inférieure à 20 µm dans le corps solide (2).

4. Procédé selon la revendication 2,
**caractérisé en ce que**
le laser (18) est réglé de telle manière que les rayons (6) émis par le laser servant à produire le plan de décollement (8) pénètrent sur une profondeur définie supérieure à 100 µm, de manière préférée supérieure à 200 µm et de manière davantage préférée supérieure à 400 µm et de manière particulièrement préférée supérieure à 700 µm dans le corps solide (2).

5. Procédé selon l'une quelconque des revendications précédentes,
**caractérisé en ce que**
le corps solide (2) est disposé au niveau d'une couche de maintien (12) servant à maintenir le corps solide (2), dans lequel la couche de maintien (12) est disposée au niveau d'une première partie de surface plane (14) du corps solide (2), dans lequel la première partie de surface plane (14) du corps solide (2) est tenue à distance d'une deuxième partie de surface plane (16) du corps solide (2) et dans lequel le plan de décollement (8) est dirigé de manière parallèle par rapport à la première partie de surface plane (14) et/ou à la deuxième partie de surface plane (16).

6. Procédé selon l'une quelconque des revendications précédentes,
**caractérisé en ce que**
le corps solide (2) présente du carbure de silicium et/ou de l'arséniure de gallium et/ou un matériau en céramique et la couche de réception est constituée d'une couche polymère (10), dans lequel la couche polymère et/ou la couche de maintien (12) sont constituées au moins en partie de PDMS, dans lequel la couche de maintien (12) est disposée au niveau d'une surface au moins par endroits plane d'un système de stabilisation (20), qui est constitué au moins en partie d'au moins un métal.

7. Procédé selon l'une quelconque des revendications précédentes,
**caractérisé en ce que**
le laser est un laser femtoseconde.

8. Procédé selon l'une quelconque des revendications précédentes,
**caractérisé en ce que**
le laser produit une durée d'impulsion inférieure à 10 ps, de manière préférée inférieure à 1 ps, et de manière particulièrement préférée inférieure à 500 fs.

9. Procédé selon l'une quelconque des revendications précédentes,
**caractérisé en ce que**
l'énergie du rayon laser, en particulier du laser femtoseconde, est choisie de telle manière que la propagation de l'endommagement dans le corps solide est inférieure à 3 fois la longueur de Rayleigh et de manière particulièrement préférée inférieure à un tiers de la longueur de Rayleigh.

10. Procédé selon l'une quelconque des revendications précédentes,
**caractérisé en ce que**
la longueur d'onde du rayon laser, en particulier du laser femtoseconde, est choisie de telle manière que l'absorption du corps solide est inférieure à 10 cm⁻¹ et de manière préférée inférieure à 1 cm⁻¹ et de manière particulièrement préférée à 0,1 cm⁻¹.

11. Procédé selon l'une quelconque des revendications précédentes,
**caractérisé en ce que**
les divers défaits résultent respectivement des suites d'une excitation multi-photon provoquée par le laser femtoseconde.
